Europäisches Patentamt

European Patent Office

Office européen des brevets

(11) Publication number: **0 025 690**
**B1**

(12) **EUROPEAN PATENT SPECIFICATION**

(45) Date of publication of patent specification: **27.03.85**

(51) Int. Cl.⁴: **H 01 L 33/00, H 01 L 21/78**

(21) Application number: **80303170.7**

(22) Date of filing: **10.09.80**

(54) **A method of producing semiconductor laser elements.**

(30) Priority: **10.09.79 JP 116002/79**

(43) Date of publication of application:
**25.03.81 Bulletin 81/12**

(45) Publication of the grant of the patent:
**27.03.85 Bulletin 85/13**

(84) Designated Contracting States:
**DE FR GB NL**

(56) References cited:
**GB-A-1 170 016**
**GB-A-2 035 684**
**US-A-3 458 369**
**US-A-3 471 923**

(73) Proprietor: **FUJITSU LIMITED**
**1015, Kamikodanaka Nakahara-ku**
**Kawasaki-shi Kanagawa 211 (JP)**

(72) Inventor: **Ohsaka, Sigeo**
**100-A-101, Idasanmai-cho Nakahara-ku**
**Kawasaki-shi Kanagawa, 211 (JP)**
Inventor: **Fujiwara, Kanji**
**1683 Shimokodanaka Nakahara-ku**
**Kawasaki-shi Kanagawa, 211 (JP)**
Inventor: **Fujiwara, Takao**
**6-5, Kamitsuruma 3-chome**
**Sagamihara-shi Kanagawa, 228 (JP)**

(74) Representative: **Bedggood, Guy Stuart et al**
**Haseltine Lake & Co. Hazlitt House 28**
**Southampton Buildings Chancery Lane**
**London WC2A 1AT (GB)**

Courier Press, Leamington Spa, England.

# Description

This invention relates to a method of producing a semiconductor laser elements.

A practical semiconductor laser element has been realized using the so-called striped structure, wherein light emitting regions are limited to stripes or comparatively narrow stripe-like areas.

A laser resonator is an indispensable requirement for securing laser operation, and in a semiconductor laser element a pair of mirrors used to provide the laser resonator are generally formed at the two ends of the laser element which orthogonally cross the longitudinal direction of the striped light emitting region of the laser element. The mirror surfaces of the laser resonator are required to be optically flat and, therefore, consideration must be given to the production of flat element end surfaces. Generally, an end surface of a laser element for forming part of the laser resonator is made by cleaving a monocrystal semiconductor wafer comprising the laser element, because the cleaved surface of a single crystal wafer has a flatness much superior to that of an ordinary mechanically formed surface.

The process for cleaving a wafer is usually carried out without regionally applying direct mechanical stress to a laser element. Regional stress produces countless minute cracks on a wafer and leaves countless convexities and concavities along the cracks on a cleaved surface, resulting in a rough surface.

In practice, a cleaving process is effected manually, for example by placing a razor blade on the wafer end and driving the blade like a wedge. Working efficiency is very poor. The reason for this is that a semiconductor laser element is generally composed of a small size chip 1 mm or less on a side. Additionally, since it is very difficult to set correctly a cleaving position, the distance between facing cleaving surfaces, namely a length of the laser resonator, is difficult to keep to a constant value. Of course, the resonator length is a significant factor in determining the oscillation characteristics of a laser element.

In US—A—3 458 369 there is described a method of producing a plurality of laser devices from a semiconductor wafer, comprising forming parallel spaced channels, by e.g. ultrasonic impact grinding, in a surface of the wafer, and cleaving the wafer along the channels.

According to the present invention there is provided a method of producing a plurality of semiconductor laser elements, each having a semiconductor body, a light emitting region in the semiconductor body, and mirror surfaces, provided by surfaces of the semiconductor body, for forming a laser resonator, in which method a semiconductor wafer is prepared from which the plurality of laser elements are to be provided, which wafer has the light emitting regions of the laser elements therein, and which method is characterised in that scratches are formed in a surface of the wafer, along lines along which the wafer is to be separated, which lines cross the light emitting regions of the laser elements, the scratches however being not provided where the lines cross the light emitting regions, and the wafer is cracked along the lines of the scratches, the cleavage surfaces formed when the wafer is cracked along those lines providing the said mirror surfaces of the laser resonators.

In place of the conventional method described earlier, the present invention can provide a method of producing semiconductor elements which offers high working efficiency and excellent resonator length reproducibility.

A method embodying this invention provides for the production of mutually separated semiconductor laser elements from a semiconductor wafer comprising many semiconductor laser elements.

A method embodying this invention provides for efficient cleaving of a semiconductor wafer in order to make mirror surfaces for laser resonators.

A method embodying this invention provides for the efficient formation of mirror surfaces for the resonators of semiconductor lasers which are of excellent flatness.

A method embodying this invention provides for the formation of mirror surfaces with high accuracy in dimensions of laser resonator length by means of an efficient cleaving process.

A method for producing a semiconductor laser element embodying this invention can provide excellent reproducibility.

A method embodying this invention provides for the production of semiconductor laser elements having stripe light emitting regions and mirrors for the laser resonators which orthogonally cross the light emitting regions and are arranged mutually face to face.

In a method embodying this invention, a semiconductor wafer wherein the active regions of semiconductor laser elements are formed is prepared.

Such a semiconductor wafer generally has a III—V compound semiconductor monocrystal body. A typical double-hetero structure laser element has a semiconductor body wherein a plurality of the monocrystal semiconductor epitaxial layers are laminated on a monocrystal substrate. An active layer which forms the light emitting regions is defined within the epitaxial layers by a couple of hetero-junctions formed in a direction vertical to the major surfaces of the epitaxial layers. In a direction along (parallel to the planes of) the major surfaces, a light emitting region is defined by a current route which is defined, for example by a selective impurity diffusion technique. Namely, the light emitting region is partly limited within the epitaxial layers. Generally, a light emitting region has the shape of a long and slender stripe.

A plurality of such striped light emitting regions are arranged in parallel within the semiconductor wafer. Such a semiconductor wafer can be built upon a conventional manner. In order to produce a large number of semiconductor laser elements, this semiconductor wafer is cleaved orthogonally of the longitudinal direction of the stripes and is divided between adjacent stripes, parallel to the longitudinal direction of the stripes.

It is a feature of one method embodying this invention to first of all provide scribes, on the semiconductor wafer, which are at right angles to the longitudinal direction of the stripes but which are excluded from light emitting regions of the wafer. These scribes, along the lines of which the wafer will be cleaved, are provided prior to the cleavage process for the semiconductor wafer. A scribing process is a process in which comparatively shallow scratches are formed on the surface of the semiconductor monocrystal part, particularly of the epitaxial layer portion of the wafer, for example, with a scriber having a diamond chip or a diamond cutter. Under the scratches made by scribing, very many comparatively deep minute cracks are formed extending towards the inside of the monocrystal wafer. A residual stress remains in a semiconductor crystal along scratches made by scribing.

As explained above, the scratches made by scribing are formed on the wafer such as to be excluded from the light emitting regions, that is, the stripes, and are formed along lines orthogonal to the longitudinal direction of the stripes. Then, a cracking process is effected by applying a stress to the wafer in such a manner that the wafer is bent backwards along a direction orthogonally crossing the scribing lines. This cracking process causes the wafer to be cracked along the scribing lines and to be severed.

Under a scratch caused by scribing, the surface exposed by the severing is rough but the area of the surface where a light emitting region is exposed has an optically flat cleavage surface. This is because cracks are not allowed to occur in the striped light emitting regions. Although a scribing scratch does not extend into a light emitting region, the scratch does extend on either side of the region. Hence, upon cleavage, the cleavage occurs along a severance crystal surface which extends along the scratch on both sides of the region and extend across the region along the line of production of the scratch, i.e. along the line which the scratch would follow if it were continued into the light emitting region. Therefore, the area of the severance surface where the light emitting region is exposed, which surface forms a mirror surface of the laser resonator, is a crystalline surface and is very flat. The laser resonator requires, of course, a pair of mirror surfaces arranged face to face and this pair of mirror surfaces are provided by a pair of element end surfaces arranged face to face.

In a method embodying this invention, a protection film for use during scribing is desirably applied to parts of a semiconductor wafer, prior to scribing of the wafer. A protection film may be composed of a resin or a metal material. Desirably, this protection film is composed of a photoresist resin, or a metal material used for forming laser element electrodes, for example gold. In particular, when the latter kind of material is used for the protection film the metal film can be used also as an element electrode. This protection film is formed on parts of the wafer covering the striped light emitting regions, the remaining areas of the wafer are exposed.

With the protection film in place scribing is actually carried out over a light emitting region, i.e. over the protection film, but the protection film prevents the scratch formation in the crystal surface below the protection film.

In other words, the thickness of the protection film, and scribing pressure, are so selected that the wafer crystal surface not protected by the protection film is scratched by scribing, but the areas of the surface protected by the protection film are not scratched by scribing.

Thus the scribing process can be realised simply by drawing a line across the wafer surface in a direction orthogonal to the light emitting region stripes by means of a diamond scriber, and this scribing can be effected very easily with an excellent reproducibility.

According to a modification of the present invention the protection film may be formed with a minute gap therein along the planned severing line. However, this gap should be restricted such that its width is narrower than the chip diameter of the scriber used so that scribing cannot cause scratches within the gap. This modification can provide considerable advantages, particularly when an element electrode acts also as the protection film. Since severing or cleaving of a wafer is carried out along the gap, there is no need to tear the electrode metal film (the protection film) in the cracking process.

Reference is made, by way of example, to the accompanying drawings, in which:—

Figure 1 is a schematic perspective view of a semiconductor laser element which can be produced by a method embodying this invention;

Figure 2 is a schematic perspective view of a part of semiconductor laser wafer produced in the course of a method embodying this invention;

Figure 3 is a cross-section of part of the wafer of Fig. 2 when subjected to a scribing process;

Figure 4A and Figure 4B are, respectively, a side view and a front view scribing apparatus employed in a method embodying this invention;

Figure 5 is a cross-sectional view schematically indicating, in part, a wafer which has been scribed;

Figure 6 is a schematic view of cracking apparatus used in a method embodying this invention;

Figure 7 is a schematic perspective view of semiconductor rods which are formed by severing a wafer in an embodiment of this invention;

Figure 8 is a graph indicating current vs. optical output characteristics of one semiconductor laser element produced by a method embodying this invention and another semiconductor laser element produced by a prior method;

Figure 9A and Figure 9B are schematic perspective views respectively of a semiconductor laser element and a wafer provided by another embodiment of this invention;

Figure 10 is a graph indicating distributions of resonator lengths of laser elements produced by a method embodying this invention and by a conventional method;

Figure 11A and Figure 11B are respectively, a perspective view of a wafer used in producing semiconductor laser elements in another embodiment of this invention, and a cross-sectional view indicating part of a wafer and a scriber in a scribing process in an embodiment of this invention.

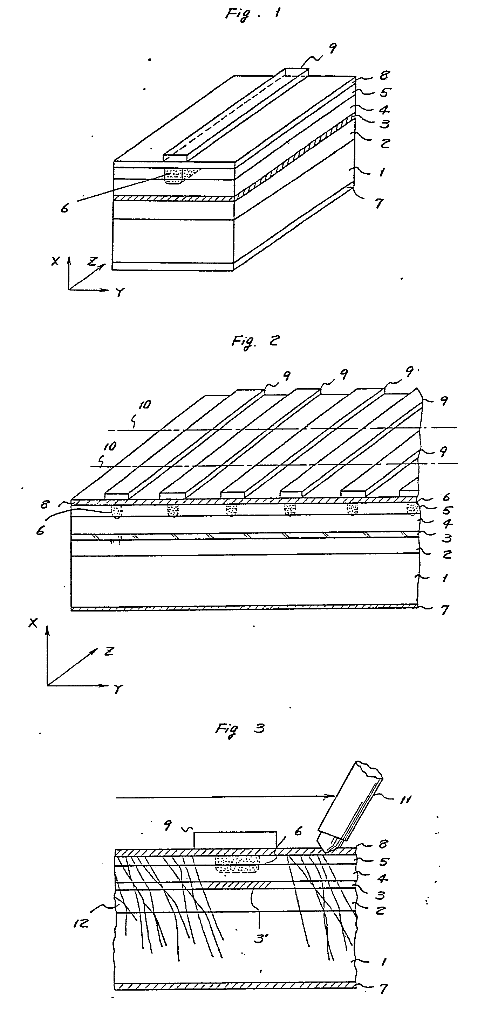

With reference to Fig. 1, a typical example of a semiconductor laser element to be produced by this invention will be described.

Figure 1 shows a semiconductor laser element, more particularly a semiconductor laser element having a double hetero (DH) structure of the GaAs—$Ga_{1-x}Al_xAs$ system. This laser element has a structure wherein a clad layer 2 of n-type GaAlAs, an active layer 3 of p-type GaAs, a clad layer 4 of p-type GaAlAs and an n-type GaAs cap layer 5 are formed in sequence by a conventional liquid phase epitaxial growth technique on an n-type GaAs substrate 1. Further, a p-type stripe region 6 is formed by diffusing Zn in the region 6, and an ohmic contact layer 7 of AuGeNi alloy, which is used as one device electrode, is provided at the rear side of the substrate 1. An ohmic contact layer 8 consisting of Ti—Pt alloy, which is used as another device electrode, and an electrode 9, consisting of a stripe-like Au plated layer facing (e.g. in register with and above) the p-type stripe region 6 are laminated and formed on the surface of the cap layer 5 of n-type GaAs.

In a semiconductor laser element having such a structure, the active layer 3 has a smaller band gap than the clad layers 2, 4 on the two sides thereof and has a large refraction coefficient. As a result, injected carriers generated by applying a voltage to the electrodes are enclosed within the active layer 3 together with light. These enclosing effects lower a threshold current level required for laser oscillation and bring about realization of continuous operation of a semiconductor junction laser element at room temperature.

In such a laser element, the surface (X—Y) at the front side in Fig. 1, and the surface at the opposite side of the laser element are formed as mirror surfaces by cleavage. Light generated within the active layer 3 under the striped region 6 is reflected by these mirror surfaces and advances or travels reciprocally in the Z-axis direction, resulting in laser oscillation. Part of such light can be obtained as a laser beam from a mirror surface.

Thus, a couple of flat surfaces facing one another and orthogonal to the Z-axis direction form the mirror surfaces for a laser resonator.

In general, a crystal orientation is selected so that the major surface of substrate 1 coincides with the crystal surface of orientation (100). Therefore, the epitaxial semiconductor layers 2, 3, 4 and 5 also have major surfaces of orientation (100). Usually, the crystal surface (110), which is at right angles to the surface (100) is selected as the cleavage surface.

A method embodying this invention for severing a wafer for providing semiconductor laser elements will be explained.

Figure 2 indicates a wafer which is prepared as a preliminary step to forming a plurality of striped laser elements. This wafer has a double hetero structure the same as that illustrated in Fig. 1 with junction structures as indicated at 1 to 8. In addition, a plurality of striped electrodes 9 which are formed, for example, by selective plating of gold (Au) in the form of stripes, with a thickness of 6 μm and a width of 70 μm, are provided on the surface of this wafer facing the striped regions 6 where Zn is diffused.

The electrodes 9 are formed continuously in the longitudinal directions of the stripes 6 even across areas between parts which will form adjacent laser elements after scribing.

The conditions required for scribing a wafer thus structured are as follows: a pressure of about 30 g is applied to a scriber (generally what is called a 3-point cutter having a diamond chip with a point angle of 110°; the point of scriber is set to a depth of 50 μm or less, from the surface (this set depth is not the actual penetration depth); and scribing is performed at the speed of 50 mm/sec along the surface in the crystal orientation (110). The actual penetration depth depends on scriber pressure, not set depth, normally.

After scribing, the wafer is cracked and separated by applying a slight force with a roller from the rear side of the wafer (the surface opposite to the scribed surface).

Figure 3 is a cross-section of a part of a wafer taken along a planned scribing line 10 in Fig. 2. In Fig. 3, scribing conditions are indicated.

When the wafer surface is scratched by a scriber 11, countless minute cracks 12 extending internally of substrate 1 are generated from the scratches caused by scribing. These cracks 12 are formed almost along the surface (110) i.e. they coincide generally with that surface. A residual stress remains within the wafer after formation of the scratches by scribing. Here, it should be noted that scribing scratches are not formed on the light emitting region 3' and the cracks 12 and the residual stress do not occur in the light emitting region 3'. This is because the protection film 9 consisting of Au protects the surface above region 3' from scribing scratches. The light emitting region 3' is located within the active layer 3, just below the p-type region 6 for defining a current route.

When the wafer is scribed, the Au layer 9 is reduced by about 3 μm in thickness along the scribed line. This value changes, of course, in dependence upon the pressure applied at the scriber point.

Experiments have demonstrated that the thickness of layer 9 is reduced by about 1 to 2 μm for a

scriber pressure of 20 g and by about 3 to 5 μm for a scriber pressure of 40 g.

At any rate, the breakdown strength of a crystal of the wafer used in this embodiment is about 105 N/cm² (10¹⁰ dyn/cm²) and therefore scribing must be effected by applying a pressure exceeding such value by means of the scriber 11.

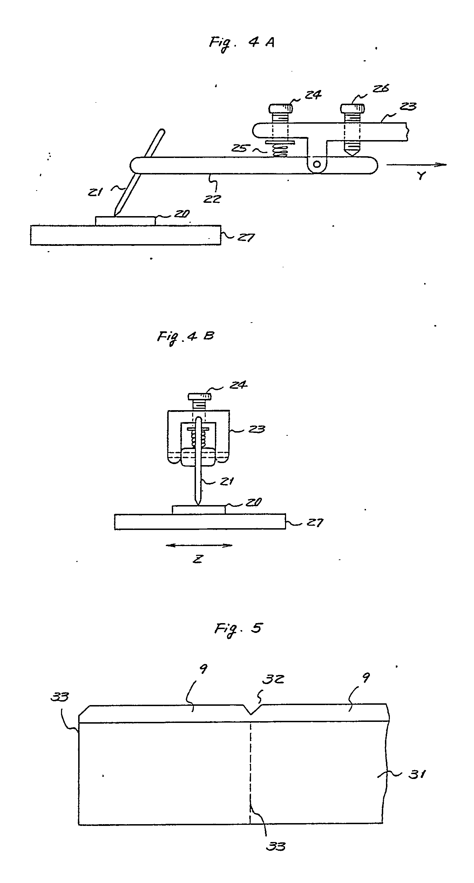

An example of a scribing apparatus used in an embodiment of this invention is indicated in Fig. 4A and Fig. 4B. Figure 4A and Fig. 4B are respectively a side view and front view of this scribing apparatus.

As indicated, a scriber 21, for scribing a wafer 20, is fixed to an arm 22. The arm 22 is supported rotatably by means of an arm support 23. An adjusting screw 24 is provided for applying a desired force to the arm 22 by means of a spring 25 and thereby the force urging the scriber 21 into the wafer can be adjusted. On the other hand, the depth of scratches made by the scriber can be set by limiting the angle through which the arm 22 can move by means of an adjusting screw 26. The arm support 23 is moved as indicated by an arrow, in a Y axis direction of the wafer 20 (see also Fig. 1) mounted on a stage 27, by means of a (not illustrated) driving system and thereby scribing is effected. On return after scribing, the arm support 23 is raised by the driving system so that the scriber 21 does not come into contact with the surface of wafer 20. Simultaneously with return operation of the arm 22 and arm support 23, along a Y axis direction opposite to the direction indicated by the arrow, the stage 27 advances in the Z direction but only by a distance which is equal to the desired resonator length. Desirably, the stage 27 provides a vacuum chuck (not illustrated) for absorbing and holding the wafer 20. The advancement of the stage 27 in the Z axis direction can be adjusted with an accuracy of 1 μm or less.

The cracking process which follows the scribing process is effected by applying a stress on the wafer such that the wafer curves backwards along the longitudinal direction of the stripes (the light emitting regions). A part of a wafer is shown in cross-sectional view taken along the longitudinal direction of the striped electrodes 9 in Fig. 5, for schematically illustrating the cracking process.

In the Au layer 9 (the striped electrode) on wafer 31, a groove 32 is formed by the scribing process. When the stress is applied as explained previously from the rear side of the wafer, the wafer is cleaved along the scribing line. Since a scratch made by scribing does not penetrate to the crystal surface under the Au layer 9, cleaving occurs along a certain crystal surface (110) 33 laying along the line of production of the scribing line on the crystal surface. Scratches caused by the scribing have a width of the order of several microns, while the crystal surface has a flatness of the order of several Å (1 Å = 10⁻¹⁰ m).

Returning again to Fig. 3, since cleaving occurs along the countless minute cracks 12 in the regions where scratches are formed on the crystal surface by the scribing, the resultant cleaved surfaces in the regions where scratches are formed on the crystal surface are very rough. This is because, although the cracks 12 are formed generally along the orientation (110), those cracks 12, which extend towards the inside of the crystal substrate from the scratches made by scribing, which scratches have a width of several microns, are capable of forming countless different surfaces in the orientation of (110).

On the other hand, cleaving is performed in such way that under the Au layer 9 only a certain crystal surface (110) 33 is exposed. The cleaved surface under this Au layer 9 is flat and works as a mirror surface for a laser resonator.

In other words, only the cleaved surface in the area where the light emitting region 3' in the active layer 3 is exposed, namely the cleaved surface in the area where the laser beam is reflected or radiated, can work as a surface for the laser resonator.

According to this invention, a cleaved surface in a region which provides a mirror surface for the laser resonator works efficiently and is very flat. Therefore, a semiconductor laser element made in accordance with this invention provides a laser resonator having satisfactory characteristics.

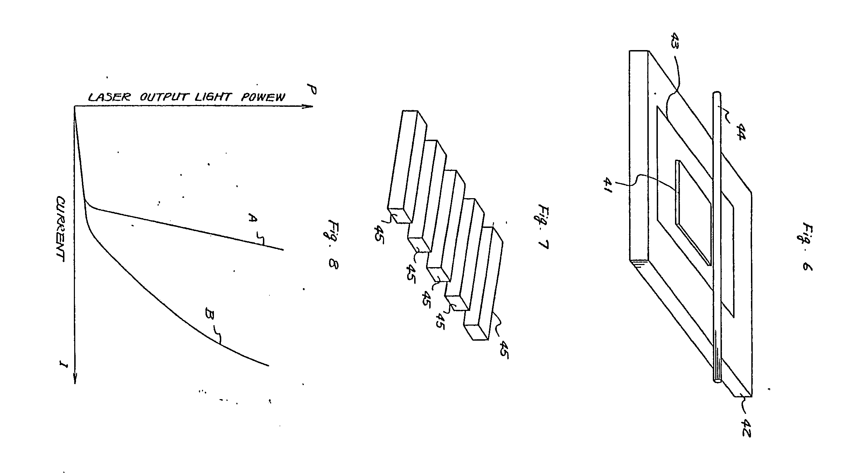

With reference to Fig. 6, a practical example of a cracking process employed in an embodiment of this invention is explained. A scribed wafer 41 is put on a flexible base such as a rubber sheet 42, desirably with an intermediate sheet of paper or resin film 43 in order to prevent contamination, with the scribed surface of the wafer facing the base 42. A roller 44 is pushed onto the rear side of wafer 41 in such a way that the longitudinal direction of the roller is parallel to the Y axis direction of the wafer, and then the roller is rolled along in the Z-axis direction. By means of this rolling, the wafer 41 is severed along a scribing line. Figure 7 schematically illustrates an array of bar-shaped semiconductor laser elements 45 obtained from the wafer by the cracking process.

Although explanation has been omitted in relation to the previously described scribing process, it is desirable to effect scribing of the wafer intermediate the adjacent Au layers 9 in a Z-axis direction, in the same way scribing is effected in the Y-axis direction.

When scribing along a Z-axis direction is performed, semiconductor laser elements as shown in Fig. 1 can be completed by separation from the array of laser elements 45 shown in Fig. 7 by rolling similar to that explained in Fig. 6 but with the roller rolled in a Y-axis direction. However, this invention is not concerned with the way in which surfaces parallel to the Z-axis are obtained.

Figure 8 is a graph which indicates current versus laser output light power characteristics for semiconductor laser elements: curve A indicates the characteristic of a laser element produced by an embodiment as described with reference to the Figures, whilst curve B indicates the characteristic of another laser element for comparison purposes.

The element used for comparison differs from the element to which curve A relates only in that Au layer 9 is not used and scratches caused by scribing are formed also on the crystal surface above the light emitting region of the element.

The fact that the element produced by the process of this invention can increase rapidly laser output light power for an increase of a current means that the element has a laser resonator of an excellent characteristic.

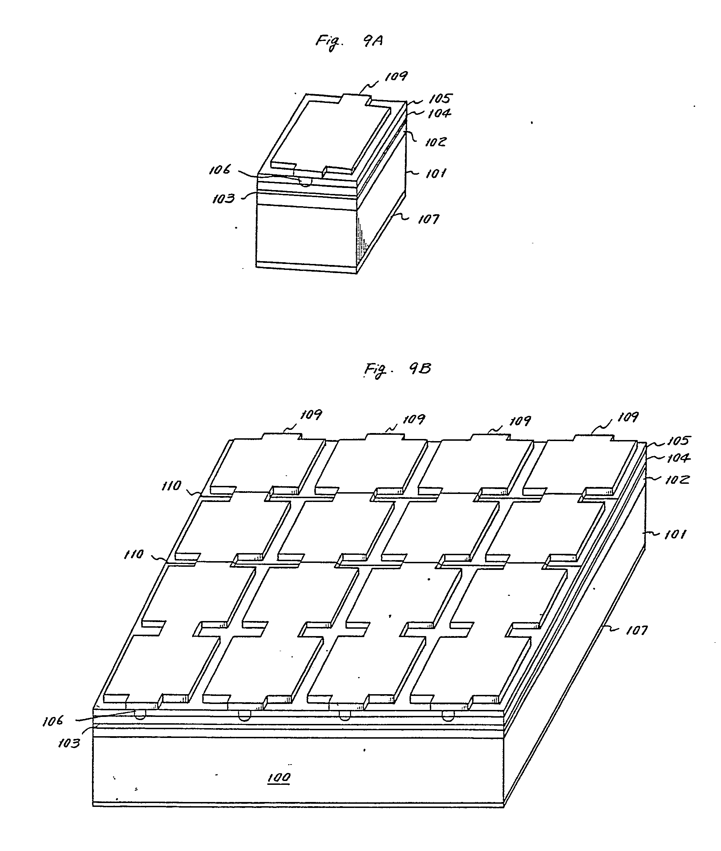

Another embodiment of this invention is explained with reference to Figs. 9(A) and 9(B). A semiconductor laser element to be produced by this embodiment of this invention is indicated in a perspective view in Fig. 9A. The structure of the crystal body of the element shown in Fig. 9A is substantially the same as that of the element indicated in Fig. 1. Namely, an n-type GaAlAs layer 102, a p-type active layer 103, a p-type GaAlAs layer 104 and an n-type GaAs layer 105 are laminated in sequence on an n-type GaAs substrate 101. Each layer can be formed by the well known epitaxial growth technique. In order to limit the light emitting region to a part of the active layer 103, a p-type region 106 is provided extending down to the p-type GaAlAs layer 104 from the surface of GaAs layer 105. The p-type region 106 has the shape of a stripe and forms a route for current flowing from the electrode 109 on the element surface to electrode 107 at the rear side of the element. Thereby, the shape of light emitting region is defined. Therefore the light emitting region of the active layer is limited to that portion directly beneath p-type region 106. Only the areas of the surfaces where the active layers 103 are exposed that are under p-type region 106 work as laser resonator mirror surfaces. Laser output light power is radiated from such a mirror surface of a resonator. Design dimensions of this laser element are 100 μm in thickness, 300 μm in length and 300 μm in width.

A method for producing a laser element indicated in Fig. 9A will be explained by referring to Fig. 9B.

In wafer 100 indicated in Fig. 9B, 16 elements each like that of Fig. 9A are shown, but actually the wafer has a size sufficiently large as to include, for example, 1600 laser elements. Electrode 109 consisting of Au works as a protection film in a scribing process. The Au layer 109 may be patterned for example by well known techniques such as a plating process and a succeeding photo-etching process.

In the embodiment of Figs. 9A and 9B, the thickness of the Au layer 109 is 1.4 μm.

A· part of an Au layer 109 along a planned scribing line has a width of 80 μm. Such parts are the "necks" of the layers 109 seen in Fig. 9B. Along a planned scribing line, the spaces between adjacent necks in adjacent Au layers 109 have a width of 220 μm. Scribing of the wafer 100 is performed by scribing apparatus as indicated in Fig. 4 using the same diamond scriber as that used in the preceding embodiment. The scribing system is so adjusted that a pressure of about 3 g is applied on the diamond chip of the scriber. This pressure causes a stress of about $10^6$ N/cm² ($10^{11}$ dyn/cm²) on the wafer crystal through the diamond chip of the scriber. Two lines of scratches 110 formed by the scribing are indicated in Fig. 9B. Observations have shown that the width of scratches 110 formed on the crystal surface is about 4 μm. Scratches 110 extend over the surfaces of the Au layers 109 but they do not reach the surface of crystal layer under the Au layers 109. Au layers are specially effective as protection films since they are, comparatively, soft enough for absorbing a pressure of scriber and effectively protect the crystal substrate from being stressed. A resin film such as a photo-resist layer can also be used as a protection film instead of an Au layer 109. However, a protection film of resin has a demerit in that it must be eliminated before completion of a laser element.

Although not illustrated, scribing is also effected between the Au layer patterns 109 in such a way as to cross orthogonally the scribe lines 110.

A cracking process is executed by the method indicated in Fig. 6.

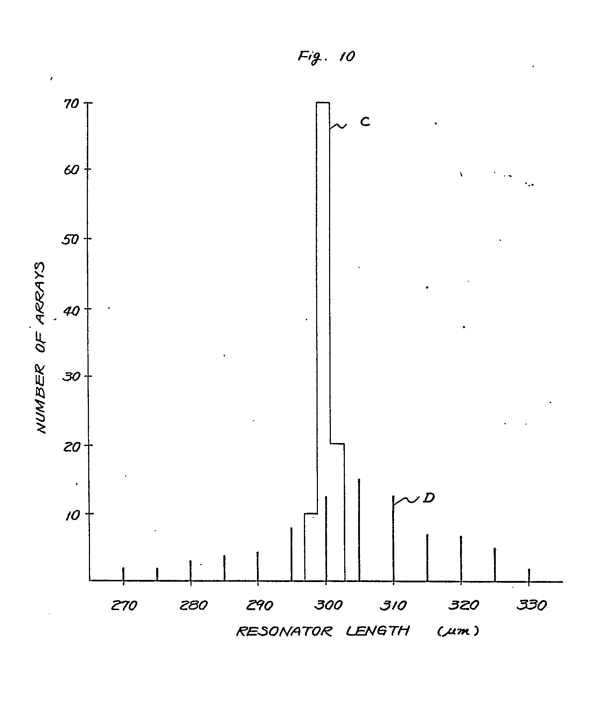

By such means, 100 laser element arrays as indicated in Fig. 7 were produced, and the distribution of widths, namely resonator lengths, of those elements was plotted. Each array had a structure wherein 40 semiconductor laser elements were coupled in a line. The distribution of resonator lengths is shown in Fig. 10. In Fig. 10, distribution C relates to the resonator lengths of 100 arrays produced in accordance with the embodiment of this invention described above. Distribution D is provided for comparison, and relates to the distribution of resonator lengths of 100 arrays produced by the conventional method using a razor blade. According to this invention, it can be understood, accurate resonator length can be obtained as designed.

In the wafer of Fig. 9B, the width of the necks of the Au layer pattern 109 formed along the scribe lines is 80 μm, but even if this width is 200 μm, an element can be formed accurately to size. In other words, when scratches made by scribing on the crystal substrate surface are formed on the substrate surface over 1/3 or more the full length of a scribe line, accurate cleavage becomes possible.

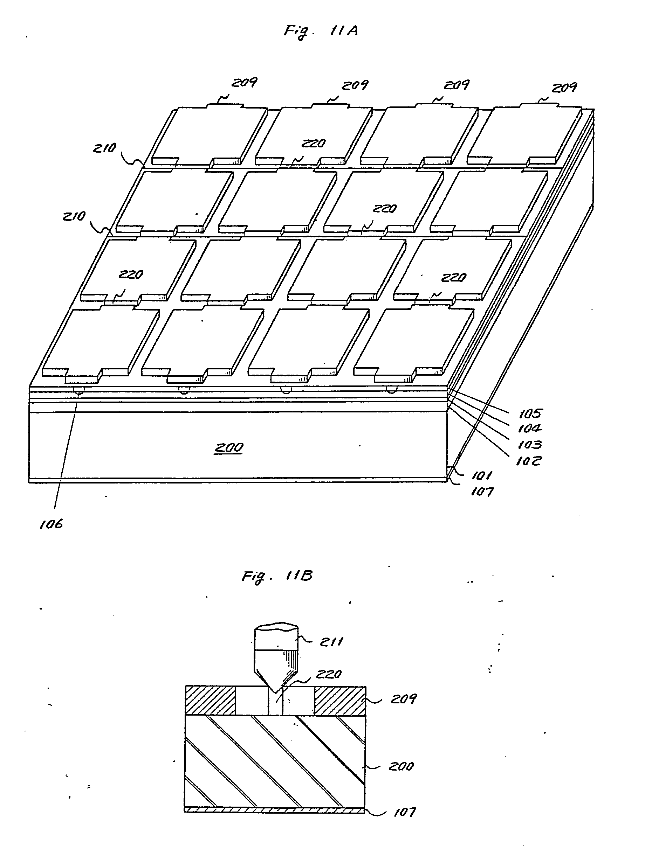

Another embodiment of this invention is illustrated with reference to Fig. 11A and Fig. 11B.

A wafer 200 indicated in Fig. 11A is different from the wafer 100 indicated in Fig. 9B only in the structure of the Au electrode layer 209 on the surface of the wafer. The pattern of Au layer 209 has small gaps 220 along the planned scribe lines.

For example, thickness of Au layer 209 is 7 μm, and in this case the width of gap 220 is, for example, 10 μm.

The art of providing a comparatively thick electrode metal layer on an element is well known as the Plated Heat Sink (PHS) technique. In case of a PHS type element, a thick metal layer works not only as an electrode but also a heat sink for heat generated in the element to counteract a temperature rise. Scribing is effected along the gaps 220.

In a case in which scribing is executed with a scriber of which razor blade angle is for example 110°, scratches are not caused on the crystal substrate surface exposed in the gaps 220. This is because the point of the diamond chip of the scriber does not reach the bottom of the gaps 220.

A cross-section of a part of wafer 200 is shown in the course of scribing in Fig. 11B. When a scriber 211 is located on a gap 220 of Au layer 209, scribing is executed by applying such a pressure to the scriber 211 that the tip of scriber 211 does not come into contact with the surface of crystal substrate 200.

Upon completion of the scribing, the wafer 200 may be severed by a cracking process similar to that described in connection with previous embodiments.

A particular advantage of the method indicated by reference to Figs. 11A and 11B is that the Au layer 209 which is used as the protection film does not need to be torn in the cracking process.

In other words, when an electrode metal film (a protection film) extends continuously over adjacent elements, and when the film is comparatively thick, even though the crystal substrate is separated along a cleavage surface in the cracking process, all elements remain coupled by the electrode metal film. Therefore, in this case, the electrode metal film must be torn.

Tearing of the electrode metal film results in a risk of producing a defective element in which the electrode metal film has not remained in place in accordance with the required electrode pattern.

However, in a case in which a film, for example a photoresist film, which may be eliminated before or after the cracking process, is used as the protection film, the need for tearing of the protection film does not arise, and the disadvantages of such tearing are avoided. As protection film, freely selected well known photoresist materials can be used. The use of photoresist, however, has a demerit in that an extra manufacturing step is required.

In relation to the embodiments of this invention described above, the structure of specific types of semiconductor laser elements have been referred to in order to give a clear explanation of the invention. However, this invention does not substantially depend upon the internal structure of the laser elements to be produced. Therefore, this invention can be adopted in relation to other kinds of semiconductor laser elements.

Thus, in this invention, a wafer wherein many semiconductor laser elements are formed is scribed and cracked in order to form the mirror surfaces of laser resonators. The scribing is executed in such a way that scratches are formed on the surface of crystal substrate, except over the light emitting regions of the laser elements. The cleaved surface formed by cracking along a scribe line is very flat in areas in which the light emitting regions are exposed.

Desirably, the wafer is covered with a protection film which lies over at least the light emitting regions, prior to the scribe process. More desirably, this protection film consists of an electrode metal such as Au or of a resin such as a photoresist material. When such a protection film is provided scribing is executed such that crystal substrate surface which is covered with the protection film is not scratched during scribing. The invention allows cleavage to be effective and results in excellent reproducibility of physical dimensions, to obtain satisfactory laser resonator characteristics.

**Claims**

1. A method of producing a plurality of semicondcutor laser elements, each having a semiconductor body, a light emitting region in the semiconductor body, and mirror surfaces provided by surfaces of the semiconductor body, for forming a laser resonator, in which method a semiconductor wafer is prepared from which the plurality of laser elements are to be provided, which wafer has the light emitting regions of the laser elements therein, and which method is characterised in that scratches are formed in a surface of the wafer, along lines along which the wafer is to be separated, which lines cross the light emitting regions of the laser elements, the scratches however being not provided where the lines cross the light emitting regions, and the wafer is cracked along the lines of the scratches, the cleavage surfaces formed when the wafer is cracked along those lines providing the said mirror surfaces of the laser resonators.

2. A method as claimed in claim 1, wherein a protective film is formed on the surface of the wafer so as to cover the regions of the surface above the light emitting regions, to protect those surface regions from scratches, but leaving other parts of that surface exposed.

3. A method as claimed in claim 2, wherein the scratches are formed on the exposed parts of the surface of the wafer and on the protective film, the scratches on the protective film not penetrating to the surface of the wafer.

4. A method as claimed in claim 1, 2 or 3, wherein the scratches are formed by scribing.

5. A method as claimed in any preceding claim, wherein each light emitting region has a stripe-like shape.

6. A method as claimed in claim 5, wherein the stripe-like emitter regions are disposed in parallel to one another, parallel to a major surface of the wafer.

7. A method as claimed in claim 2 or 3, or claim 4, 5 or 6 read as appended to claim 2 or 3, wherein the protective film is provided with gaps along each of the lines of scratches, each gap being so narrow as to prevent scratches from being formed on the surface of the wafer in the gap.

8. A method as claimed in claim 2, or any one of claims 3 to 7 when read as appended to claim 2, wherein the protective film comprises a metal.

9. A method as claimed in claim 8, wherein the metal is gold.

10. A method as claimed in claim 8 or 9, wherein the protective film is a metal film which serves as a laser element electrode.

11. A method as claimed in claim 2, or any one of claims 3 to 7 when read as appended to claim 2, wherein the protective film comprises a resin.

12. A method as claimed in claim 11, wherein the protective film comprises a photoresist.

**Patentansprüche**

1. Verfahren zum Herstellen einer Vielzahl von Halbleiterlaserelementen, die jeweils einen Halbleiterkörper, einen Licht emittierenden Bereich in dem Halbleiterkörper und Spiegeloberflächen aufweisen, die durch Oberflächen des Halbleiterkörpers gebildet werden um einen Laserresonator zu bilden, bei welchem ein Halbleiterplättchen vorbereitet wird, von dem eine Vielzahl von Laserelementen gebildet werden sollen und das Licht emittierende Bereiche des Laserelements enthält, dadurch gekennzeichnet, daß Risse in der Oberfläche des Plättchens längs Linien gebildet werden, längs denen das Plättchen getrennt werden soll, und die Linien sich quer über die Licht emittierenden Bereiche der Laserelemente erstrecken, daß jedoch dort, wo die Linien die Licht emittierenden Bereiche kreuzen, keine Risse vorgesehen werden, und daß die Plättchen längs den Rißlinien gebrochen werden, und die Spaltoberflächen gebildet werden, wenn das Plättchen längs jenen Linien gebrochen wird, welche die genannten Spiegeloberflächen des Laserresonators bilden.

2. Verfahren nach Anspruch 1, bei dem ein Schutzfilm auf der Oberfläche des Plättchens gebildet wird, um die Bereiche der Oberfläche oberhalb der Licht emittierenden Bereiche zu bedecken, um jene Oberflächenbereiche vor Rissen zu schützen, jedoch andere Teile der Oberfläche exponiert lassen.

3. Verfahren nach Anspruch 2, bei dem die Risse auf den exponierten Teilen der Oberfläche des Plättchens und auf dem Schutzfilm gebildet werden, und daß die Risse auf dem Schutzfilm nicht zu der Oberfläche des Plättchens durchdringen.

4. Verfahren nach Anspruch 1, 2 oder 3, bei dem die Risse durch Anreißen gebildet werden.

5. Verfahren nach einem der vorhergehenden Ansprüche, bei dem jeder Licht emittierende Bereich eine Streifenform hat.

6. Verfahren nach Anspruch 5, bei dem die streifenförmigen Emitterbereiche parallel zueinander und parallel zu einer Hauptoberfläche des Plättchens angeordnet werden.

7. Verfahren nach Anspruch 2 oder 3, oder nach Anspruch 4, 5 oder 6 in Verbindung mit Anspruch 2 oder 3, bei dem der Schutzfilm Spalten längs jeder Linie oder jedem Riß aufweist und jeder Spalt so schmal ist, daß keine Risse auf der Oberfläche des Wafers in dem Spalt gebildet werden können.

8. Verfahren nach Anspruch 2, oder nach einem der Ansprüche 3 bis 7 in Verbindung mit Anspruch 2, bei dem der Schutzfilm ein Metall umfaßt.

9. Verfahren nach Anspruch 8, bei dem das Metall Gold ist.

10. Verfahren nach Anspruch 8 oder 9, bei dem der Schutzfilm ein Metallfilm ist, der als Laserelementelektrode dient.

11. Verfahren nach Anspruch 2, oder nach einem der Ansprüche 3 bis 7 in Verbindung mit Anspruch 2, bei dem der Schutzfilm ein Harz umfaßt.

12. Verfahren nach Anspruch 11, bei dem der Schutzfilm ein Photoresist umfaßt.

**Revendications**

1. Procédé de fabrication de plusieurs éléments lasers à semi-conducteur ayant chacun un corps semi-conducteur, une région photoémissive formée dans le corps et des surfaces de miroir formées par des surfaces du corps, afin qu'un résonateur laser soit formé, procédé selon lequel une plaquette semi-conductrice est préparée et plusieurs éléments lasers sont destinés à être formés à partir de celle-ci, la plaquette ayant les régions photoémissives des éléments lasers, et le procédé est caractérisé en ce que des rayures sont formées à une surface de la plaquette, le long d'axes suivant lesquels la plaquette doit être séparée, ces axes recoupant les régions photoémissives des éléments lasers, les rayures n'étant cependant pas formées aux endroits où les axes recoupent les régions photoémissives, et la plaquette est cassée le long des axes des rayures, les surfaces de clivage formées lorsque la plaquette est cassée le long de ces axes formant les surfaces des miroirs des résonateurs lasers.

2. Procédé selon la revendication 1, caractérisé en ce qu'un film protecteur est formé à la surface de la plaquette afin qu'il recouvre les régions de la surface se trouvant au-dessus des régions photoémissives, afin que ces régions de surfaces soient protégées contre les rayures mais que d'autres parties de surface restent exposées.

3. Procédé selon la revendication 2, dans lequel les rayures sont formées sur les parties exposées de la surface de la plaquette et sur le film protecteur, les rayures formées sur le film protecteur ne pénètrant pas jusqu'à la surface de la plaquette.

4. Procédé selon l'une quelconque des revendications 1 à 3, dans lequel les rayures sont formées par traçage.

5. Procédé selon l'une quelconque des revendications précédentes, dans lequel chaque région photoémissive a la forme d'une bande étroite.

6. Procédé selon la revendication 5, dans lequel les régions d'émetteurs analogues à des bandes étroites sont disposées parallèlement les unes aux autres, parallèlement à une grande face de la plaquette.

7. Procédé selon l'une des revendications 2 ou 3 ou l'une des revendications 4, 5 ou 6 prises avec l'une des revendications 2 et 3, dans lequel le film protecteur est réalisé avec des espaces le long de chacun de axes des rayures, chaque espace étant si étroit que des rayures ne peuvent pas être formées à la surface de la plaquette dans ledit espace.

8. Procédé selon la revendication 2 ou selon l'une quelconque des revendications 3 à 7 prises ensemble avec la revendication 2, dans lequel le film protecteur est un métal.

9. Procédé selon la revendication 8, caractérisé en ce que le métal est l'or.

10. Procédé selon l'une des revendications 8 et 9, dans lequel le film protecteur est un film métallique qui joue le rôle d'une électrode de l'élément laser.

11. Procédé selon la revendication 2 ou l'une quelconque des revendications 3 à 7 prises avec la revendication 2, dans lequel le film protecteur est une résine.

12. Procédé selon la revendication 11, dans lequel le film protecteur est une réserve photographique.

Fig . 1

Fig. 2

Fig 3

1

Fig. 4 A

Fig. 4 B

Fig. 5

Fig. 6

Fig. 7

Fig. 8

Fig. 9A

Fig. 9B

Fig. 10

Fig. 11A

Fig. 11B